Europäisches Patentamt

European Patent Office

Office européen des brevets

(19)

(11) Veröffentlichungsnummer: **0 311 128 B1**

(12) # EUROPÄISCHE PATENTSCHRIFT

(45) Veröffentlichungstag der Patentschrift: **10.06.92**

(21) Anmeldenummer: **88116708.4**

(22) Anmeldetag: **07.10.88**

(51) Int. Cl.5: **H03K  17/95**, G01F 1/075, H03B 11/00

---

(54) **Verfahren und Vorrichtung zur Erregung eines Schwingkreises.**

---

(30) Priorität: **07.10.87 DE 3733943**

(43) Veröffentlichungstag der Anmeldung:
**12.04.89 Patentblatt  89/15**

(45) Bekanntmachung des Hinweises auf die
Patenterteilung:
**10.06.92 Patentblatt  92/24**

(84) Benannte Vertragsstaaten:
**DE ES FR GB IT NL**

(56) Entgegenhaltungen:
**EP-A- 0 021 978**
**EP-A- 0 156 696**
**EP-A- 0 228 019**
**DE-A- 1 957 103**
**GB-A- 2 204 135**

(73) Patentinhaber: **ANDRAE LEONBERG GMBH**
**Neue Ramtelstrasse 48**
**W-7520 Leonberg(DE)**

Patentinhaber: **A. STEUDLER GMBH  +  CO. KG**
**Durlacher Strasse 35**
**W-7530 Pforzheim(DE)**

(72) Erfinder: **Förster, Michael, Dipl.-Ing.**
**Nauener Strasse 19a**
**W-7000 Stuttgart 70(DE)**
Erfinder: **Hentzschel, Hans-Peter, Dr. rer. nat.**
**Osserstrasse 34**
**W-8000 München 80(DE)**
Erfinder: **Leiter, Alfred**
**Gesellstrasse 67a**
**W-7530 Pforzheim(DE)**
Erfinder: **Weber, Gerhard**
**Steigäckerstrasse 36**
**W-7142 Marbach/Neckar(DE)**

(74) Vertreter: **Zinnecker, Armin, Dipl.-Ing. Lorenz-Seidler-Gossel**
**Widenmayerstrasse 23**
**W-8000 München 22(DE)**

EP 0 311 128 B1

# Beschreibung

Die Erfindung betrifft ein Verfahren zur Erregung eines parallelen Schwingkreises nach dem Oberbegriff des Anspruchs 1 und ein Verfahren zur Erregung eines Serienschwingkreises nach dem Oberbegriff des Anspruchs 2. Weiterhin betrifft die Erfindung einen induktiven Näherungssensor zur Durchführung eines derartigen Verfahrens mit einem durch Annähern eines elektrisch leitenden Gegenstandes (Dämpfungsglied) bedämpfbaren parallelen Schwingkreis oder Serienschwingkreis sowie einen Durchflußmengenzähler, insbesondere Wasserzähler, mit einem derartigen induktiven Näherungssensor.

Schwingungen in einem LC-Schwingkreis werden bei vielen Anwendungen benötigt. Diese Schwingungen können auch auf vielfältige Weise erzeugt werden. Die Schwingung ist in der Praxis stets mehr oder weniger gedämpft, wobei der Grad der Dämpfung von der Güte des Schwingkreises abhängt.

Schwingkreise werden bei induktiven Näherungssensoren verwendet. Ein derartiger induktiver Näherungssensor ist beispielsweise aus der DE-A-33 18 900 bekannt. Die Dämpfung des in dem Näherungssensor vorhandenen LC-Schwingkreises ist durch die Annäherung eines elektrisch leitfähigen Gegenstandes (Dämpfungsglied) beeinflußbar. Je kürzer der Abstand zwischen dem induktiven Näherungssensor und dem elektrisch leitfähigen Gegenstand ist, desto stärker ist die Dämpfung der freien Schwingungen des Schwingkreises. Der Näherungssensor kann also zur Entfernungsmessung verwendet werden.

Insbesondere kann ein induktiver Näherungssensor dazu verwendet werden, den Vorbeigang eines elektrisch leitenden Gegenstandes (Dämpfungsglied) festzustellen. Diese Anwendung ist insbesondere bei Durchflußmengenzählern, beispielsweise Wasserzählern, von Bedeutung. Das Dämpfungsglied besteht in diesem Fall aus einem Zeiger oder einem sonstigen bewegten Glied des Durchflußmengenzählers. Dieser Zeiger kann beispielsweise bei jedem Umlauf einmal in den Bereich des Näherungssensors gelangen.

Aus der EP-A 0 228 019 ist ein induktiver Näherungsschalter bekannt, d.h. ein Näherungssensor mit einer Schaltstufe, mit einem durch Annähern eines elektrisch leitenden Gegenstandes bedämpfbaren, aus einer Induktivität und einer Kapazität bestehenden Parallel-Schwingkreis, sowie mit einer durch einen Schalter schaltbaren Gleichstromquelle und einer Steuerschaltung zum Schließen und Öffnen des Schalters. Dabei wird der Schalter periodisch jeweils so lange geschlossen, daß eine ausreichende Zahl von Schwingungsperioden des Parallel-Schwingkreises erkannt wird, und anschließend wieder geöffnet, wobei die Zahl der Wiederholungen variabel gestaltet werden kann.

Aufgabe der Erfindung ist es, ein Verfahren zur Erregung eines parallelen Schwingkreises oder eines Serienschwingkreises nach dem Oberbegriff der Ansprüche 1 und 2 anzugeben, bei dem der Energieverbrauch für die Erzeugung der Schwingung möglichst gering ist. Eine weitere Aufgabe der Erfindung ist es, einen induktiven Näherungssensor zu schaffen, der das soeben angegebene Verfahren verwendet. Eine weitere Aufgabe der Erfindung ist es, einen Durchflußmengenzähler zu schaffen, der von einem induktiven Näherungssensor der soeben angegebenen Art Gebrauch macht.

Erfindungsgemäß wird diese Aufgabe bei einem parallelen Schwingkreis durch die im kennzeichnenden Teil des Anspruchs 1 angegebenen Merkmale gelöst. Bei einem Serienschwingkreis wird diese Aufgabe durch die im nebengeordneten Anspruch 2 angegebenen Merkmale gelöst. In beiden Fällen, also sowohl beim parallelen Schwingkreis als auch beim Serienschwingkreis, wird demnach nicht abgewartet, bis der Schwingkreis den Grenzwert des Energieinhaltes erreicht hat. Der Schalter wird vielmehr bereits dann wieder geöffnet bzw. umgeschaltet, wenn die Steuerschaltung das Vorhandensein ausreichender Schwingung erkannt hat. Die Schwingung muß dabei in dem Sinne "ausreichend" sein, daß nach dem Öffnen bzw. Umschalten eine zur Auswertung ausreichende Schwingungsamplitude entsteht.

Die Erregung des Schwingkreises kann periodisch wiederholt werden. Durch die Öffnung bzw. Umschaltung nach einer im Verhältnis zur Anregungswiederholperiode kurzen Zeit wird der mittlere Energieverbrauch äußerst gering gehalten. Diese Wirkung wird verstärkt dadurch, daß die Gleichstromverluste, insbesondere in der Induktivität, durch die zeitliche Begrenzung der Anregung reduziert werden.

Bei dem aus der DE-A-33 18 900 vorbekannten induktiven Näherungssensor wird der Schwingkreis durch einen Impuls von vorgegebener, konstanter Länge angeregt. Die Anregung erfolgt also unabhängig von den Bedingungen im Schwingkreis. Demgegenüber erfolgt die Beendigung des Erregungsimpulses bei der Erfindung in Abhängigkeit des Zustandes des Schwingkreises. Die Steuerschaltung ist mit dem Schwingkreis verbunden. Sobald die Steuerschaltung eine ausreichende Schwingung erkannt hat, wird der Schalter geschlossen bzw. der Umschalter in seine zweite Lage gebracht. Es findet also eine Rückkopplung des Schwingkreises zum Schalter bzw. Umschalter statt. Hierdurch ergeben sich gegenüber dem vorbekannten, mit Anregungsimpulsen konstanter, vorgegebener Länge arbeitenden induktiven Näherungssensor folgende Vorteile: Das erfindungsgemäße Verfahren arbeitet auch bei einer Änderung der Betriebsspannung mit gleichbleibender Effizienz. Die Betriebsspannung kann sich durch die allmähliche Erschöpfung einer Batterie ändern. Weiterhin können die Betriebsspannung und sonstige Schaltungsparameter aufgrund von Temperaturänderungen schwanken. Schließlich ergeben sich Parameteränderungen dadurch, daß die Schaltungen (IC-Schaltungen) in der Praxis nicht vollkommen identisch ausgeführt werden können. Weiterhin ist das erfindungsgemäße Verfahren durch die soeben beschriebene Rückkopplung unabhängig gegenüber Toleranzen in den Betriebsbedingungen, den Umgebungsbedingungen und den Bauteilen.

Das erfindungsgemäße Verfahren kann sowohl mit einem Parallel-als auch mit einem Serienschwingkreis realisiert werden. Dabei ist es praktisch nicht von Bedeutung, wie gut die realisierte Strom- bzw. Spannungsquelle einer idealen Strom- oder Spannungsquelle angenähert ist. Es versteht sich, daß bei der Realisierung Maßnahmen zu treffen sind, die unzulässige, für die Bauteile möglicherweise gefährliche oder zerstörende Spannungs-oder Stromspitzen verhindern.

Die Verwendung eines Parallel-Schwingkreises hat den Vorteil, daß dieser Schwingkreis lediglich abgeschaltet werden muß. Im Falle des Reihenschwingkreises muß zusätzlich der Schwingkreis nach dem Abschalten der Spannungsquelle überbrückt werden. Weiterhin kommt beim Serienschwingkreis noch zwangsläufig der Widerstand des Schalters und der Spannungsquelle hinzu, wodurch die Güte des Schwingkreises schlechter wird.

Die Erfindung ist dadurch gekennzeichnet, daß der Schalter bzw. Umschalter wieder geöffnet wird bzw. in die zweite Lage gebracht wird, sobald die Spannung über der Kapazität sich in der Nähe eines Extremwertes befindet und der Gradient des Stromes durch die Induktivität so gerichtet ist, daß die beim Abschalten entstehende Induktionsspannung die Schwingung verstärkt. Dies ist sowohl beim Parallel- als auch beim Serienschwingkreis anwendbar. Es wird der optimale Zeitpunkt für die Abschaltung der Stromquelle bzw. der Spannungsquelle verwendet.

Nach einer vorteilhaften Weiterbildung wird der Schalter bzw. Umschalter wieder geöffnet bzw. in die zweite Lage gebracht, sobald die Spannung über der Kapazität sich in der Nähe des ersten Extremwertes befindet und der Gradient des Stromes durch die Induktivität so gerichtet ist, daß die beim Abschalten entstehende Induktionsspannung die Schwingung verstärkt. Aufgrund der unvermeidlichen Dämpfung ist dieser erste Extremwert größer als alle nachfolgenden Extremwerte, so daß zur Erzeugung einer bestimmten Schwingungsamplitude die geringstmögliche Energie benötigt wird.

Eine weitere vorteilhafte Weiterbildung der Erfindung ist dadurch gekennzeichnet, daß der Schalter bzw. Umschalter geöffnet bzw. in die zweite Lage gebracht wird, wenn die Spannung über der Kapazität sich in der Nähe eines Nulldurchganges befindet. Hinsichtlich des Energieverbrauches ist dieser Abschaltzeitpunkt nicht ganz so günstig wie derjenige der oben beschriebenen Extremwerte. Andererseits kann bei bestimmten Realisierungen der Zeitpunkt des Nulldurchganges einfacher ermittelt werden. Auch beim Abschalten zum Zeitpunkt des Nulldurchganges ergibt sich eine für praktische Anwendungen ausreichende Schwingungsamplitude.

Wenn als Abschaltzeitpunkt der Zeitpunkt des ersten Nulldurchganges gewählt wird, ergibt sich der im Verhältnis zu den anderen Nulldurchgangszeitpunkten geringste Energieverbrauch.

Eine vorteilhafte Ausbildung der Erfindung ist dadurch gekennzeichnet, daß die Stromquelle bzw. Spannungsquelle über ein Koppelglied aus Kapazität oder Induktivität oder Widerstand oder einer Kombination dieser Elemente mit dem Schwingkreis verbunden ist.

Bei der Verwendung eines Widerstands ergibt sich folgender Vorteil: In der praktischen Ausführung hat der Schalter auch dann einen Innenwiderstand, wenn er geschlossen ist. Dieser Widerstand ist bei der praktischen Realisierung nicht stets gleich groß, sondern spannungsabhängig und herstellungsabhängig. Durch den zusätzlichen Widerstand können diese Toleranzen in ihrer Wirkung vermindert werden. Wenn beispielsweise das Größenverhältnis zwischen dem externen, zusätzlichen Widerstand und dem Innenwiderstand des Schalters etwa 10 : 1 beträgt, kann die Größe des Schalter- Innenwiderstandes gegenüber dem zusätzlichen Widerstand vernachlässigt werden. Hierdurch wird die Abhängigkeit von den Toleranzen des Schalterwiderstandes in ausreichendem Maß herabgesetzt.

Wenn als zusätzliches Bauteil ein Kondensator verwendet wird, ergeben sich folgende Vorteile: Zum einen wird der Schwingkreis entkoppelt, da der Kondensator einen unendlich großen Gleichstromwiderstand aufweist. Zum anderen ist beim Schalten der Stromsprung geringer. Dies hat zur Folge, daß die Induktionsspannungsspitze geringer ist und daß es damit nicht mehr so entscheidend darauf ankommt, den exakt richtigen Abschaltzeitpunkt zu treffen. Hierfür wird in Kauf genommen, daß die Verstärkung der Schwingung durch die Induktionsspannung geringer ist. Eine zusätzliche Induktivität zwischen der Gleichspannungsquelle und dem Schwingkreis hat im Verhältnis zur Kapazität den umgekehrten Effekt.

Wegen der bekannten Eigenschaften von Halbleiterschaltern, wie geringer Verbrauch an Steuerenergie, hohe Schaltgeschwindigkeit, kein Prellen, gute Integrierbarkeit in Schaltungen, ergibt sich eine vorteilhafte Ausführung der Erfindung unter Verwendung eines solchen Halbleiterschalters.

Die Steuerschaltung kann über ein Koppelglied aus Kapazität oder Induktivität oder Widerstand oder einer Kombination dieser Elemente mit dem Schwingkreis verbunden sein. Die Steuerschaltung kann ein Differenzierglied zur Erkennung der Extremwerte der Spannung über der Kapazität oder Induktivität aufweisen.

In vorteilhafter Weiterbildung der Erfindung kann die Steuerschaltung einen Schwellenwertschalter enthalten, der ausreichende Schwingung aufgrund Überschreiten einer Grenzspannung signalisiert.

Wenn die Steuerschaltung die Schwingungen in Impulse wandelt, können die Vorteile einer digitalen Signalverarbeitung genutzt werden. Die Auswerteschaltung kann selbst bereits digital arbeiten. Es kann aber beispielsweise auch eine nachfolgende Zählschaltung angesteuert werden.

Eine vorteilhafte Weiterbildung der Erfindung ist dadurch gekennzeichnet, daß die Schwingungen zunächst durch einen übersteuerten Verstärker verstärkt werden und anschließend durch einen Schmitt-Trigger in Rechteckimpulse konstanter Amplitude (digitale Ausgangswerte) gewandelt werden, solange die ansteigende Flanke der verstärkten Schwingung eine obere Grenze überschreitet oder die abfallende Flanke der verstärkten Schwingung eine untere Grenze unterschreitet.

Die Erfindung schafft weiterhin einer induktiven Näherungssensor, der von dem erfindungsgemäßen Verfahren Gebrauch macht. Der induktive Näherungssensor besitzt einen durch Annähern eines elektrisch leitenden Gegenstandes (Dämpfungsglied) bedämpfbaren LC-Schwingkreis. Weiterhin ist eine Auswerteschaltung zur Ermittlung der Schwingungsdämpfung vorgesehen.

Ein derartiger induktiver Näherungssensor ist aus der DE-A-33 18 900 bekannt. Dieser Näherungssensor beruht auf folgendem Prinzip: Nach der Anregung des LC-Schwingkreises schwingt dieser mit einer bestimmten, durch die Induktivität und Kapazität vorgegebenen Frequenz. Wenn sich das Dämpfungsglied außerhalb des Einwirkungsbereichs des induktiven Näherungssensors befindet, klingt diese Schwingung relativ langsam ab. Der Grad der Dämpfung der vom Dämpfungsglied unbeeinflußten Schwingung hängt dabei von der Güte des Schwingkreises ab. Wenn das Dämpfungsglied in den Einwirkungsbereich des induktiven Näherungssensors gelangt, wird die in dem LC-Schwingkreis erzeugt Schwingung stärker gedämpft. Der Dämpfungsgrad hängt dabei von dem Dämpfungsglied und von anderen Parametern, beispielsweise von der Entfernung des Dämpfungsgliedes von dem induktiven Näherungssensor ab. Der induktive Näherungssensor ist also zur Entfernungsmessung geeignet, da die im LC-Schwingkreis des Näherungssensors erzeugt Dämpfung ein Maß für die Entfernung des Dämpfungsgliedes liefert.

Zur Bestimmung des Dämpfungsgrades wird bei dem aus der DE-OS 33 18 900 vorbekannten induktiven Näherungssensor der Mittelwert der gleichgerichteten Schwingung gebildet. Je kleiner dieser Mittelwert ist, desto größer ist die Dämpfung. Eine weitere Möglichkeit zur Bestimmung der Dämpfung besteht darin, zu einem bestimmten Zeitpunkt nach der Anregung des LC-Schwingkreises die Höhe der Amplitude der abklingenden Schwingung zu bestimmen.

Eine weitere Aufgabe der Erfindung ist es daher, einen induktiven Näherungssensor zu schaffen, der eine besonders einfache und zuverlässige Bestimmung der Schwingungsdämpfung ermöglicht.

Erfindungsgemäß wird diese Aufgabe dadurch gelöst, daß die Auswerteschaltung eine Zählschaltung beinhaltet, die die Anzahl der Schwingungen zählt, deren Amplitude einen vorwählbaren Wert überschreitet. Diese Art der Auswertung ist deshalb besonders einfach, weil auf analoge Bauteile verzichtet werden kann, die Auswertung also ausschließlich auf digitale Weise erfolgt. Der ermittelte Dämpfungsgrad kann auch auf digitale Weise weiterverarbeitet werden, ohne daß er vorher durch einen Analog-Digital-wandler erst in einen digitalen Wert umgewandelt werden müßte.

In einer vorteilhaften Weiterbildung der Erfindung beinhaltet die Steuerschaltung einen übersteuerten Verstärker. Durch diesen werden die Schwingungen zunächst verstärkt. Anschließend werden die verstärkten Schwingungen durch einen Schmitt-Trigger in Rechteckimpulse konstanter Amplitude, also in digitale Ausgangswerte gewandelt, solange die ansteigende Flanke der verstärkten Schwingung einen obere Grenze überschreitet oder die abfallende Flanke der verstärkten Schwingung eine untere Grenze unterschreitet. Ansonsten wird der erreichte Pegel beibehalten, also einer der beiden digitalen Werte statisch eingenommen. Hierdurch ergibt sich der Vorteil, daß bereits von der Auswerteschaltung ein digitalisiertes Signal erzeugt wird, welches ein Maß für die Dämpfung liefert und welches auf bekannte Weise einfach digital weiterverarbeitet werden kann. Für die weitere Auswertung des von der Auswerteschaltung gelieferten digitalen Signals sind also Standardbauteile verwendbar.

Eine weitere vorteilhafte Weiterbildung der Erfindung ist gekennzeichnet durch einen Pulsgeber zur periodischen Erregung des LC-Schwingkreises. Der zeitliche Abstand der periodischen Erregungen maß dabei größer sein als die Schwingungszeit, die ausgewertet wird. Dies kann die praktische Abklingdauer der Schwingung des LC-Schwingkreises (unter einen verwertbaren Pegel) im von Dämpfungsglied unbeeinflußten Zustand sein. Die periodische Erregung kann mit konstanter Frequenz erfolgen. Diese ist jedoch nicht zwingend. Es ist auch möglich, den LC-Schwingkreis nach einem vorgegebenen Programm periodisch zu erregen. Weiterhin kann der LC-Schwingkreis in Abhängigkeit gewisser Zustände oder Ereignisse erregt werden.

Eine weitere Aufgabe der Erfindung besteht schließlich darin, einen Durchflußmengenzähler, insbesondere einen Wasserzähler, zu schaffen, der unter Verwendung eines induktiven Näherungssensors und/oder unter Verwendung des erfindungsgemäßen Verfahrens arbeitet.

Ausführungsbeispiele der Erfindung werden nachstehend anhand der beigefügten Zeichnungen im einzelnen erläutert. In den Zeichnungen zeigt

Fig. 1 das Grundschaltbild für einen Parallelschwingkreis,

Fig. 2 das Grundschaltbild für einen Serienschwingkreis,

Fig. 3 ein abgewandeltes Schaltbild mit einem Kondensator als Koppelglied zur Stromquelle und einem Kondensator als Koppelglied zur Steuerschaltung,

Fig. 4 den Verlauf der Kondensatorspannung über der Zeit nach dem Einschalten des Schalters bei einem Parallelschwingkreis,

Fig. 5 einen Schwingungsverlauf bei schwach gedämpfter Schwingung,

Fig. 6 einen Schwingungsverlauf bei gedämpfter Schwingung und

Fig. 7 einen weiteren Schwingungsverlauf.

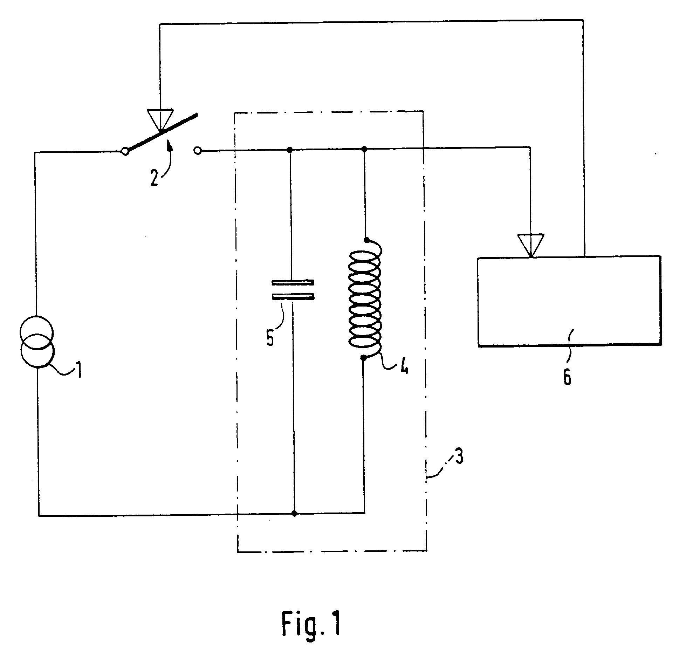

Das in Fig. 1 dargestellte Grundschaltbild für einen Parallelschwingkreis besteht aus einer Gleichsstromquelle 1, einem Schalter 2, einem Schwingkreis 3 mit einer Induktivität 4 und einer Kapazität 5, sowie einer Steuerschaltung 6. Die Gleichstromquelle kann durch eine Batterie realisiert werden. Die Steuerschaltung 6 empfängt das vom Schwingkreis 3 abgegriffene Signal, verarbeitet diese und steuert in Abhängigkeit von dieser Verarbeitung das Öffnen und das Schließen des Schalters 2.

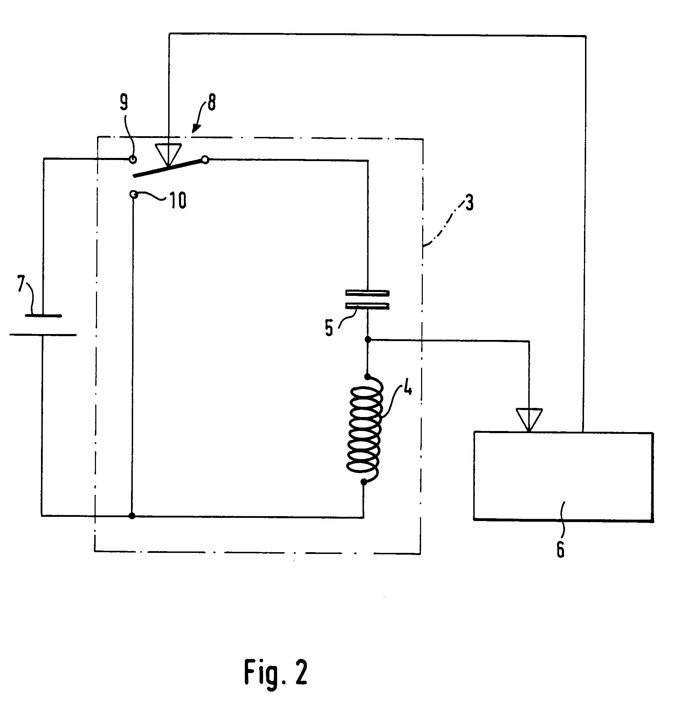

Das in Fig. 2 dargestellte Grundschaltbild für einen Serienschwingkreis besteht aus einer Gleichspannungsquelle 7, einem Umschalter 8, einem Schwingkreis 3 mit einer Induktivität 4 und einer Kapazität 5, sowie einer Steuerschaltung 6. Der Umschalter 8 kann in eine erste Stellung 9 gebracht werden, in der er den Schwingkreis 3 mit der Spannungsquelle 7 Reihe schaltet, und in eine zweite Stellung 10, in der er den Schwingkreis 3 schließt und von der Spannungsquelle 7 abtrennt. Zwischen der Kapazität 5 und der Induktivität 4 wird ein Signal abgegriffen und der steuerschaltung 6 zugeführt. In Abhängigkeit von der Verarbeitung dieses Signals in der Steuerschaltung 6 wird der Umschalter 8 gesteuert.

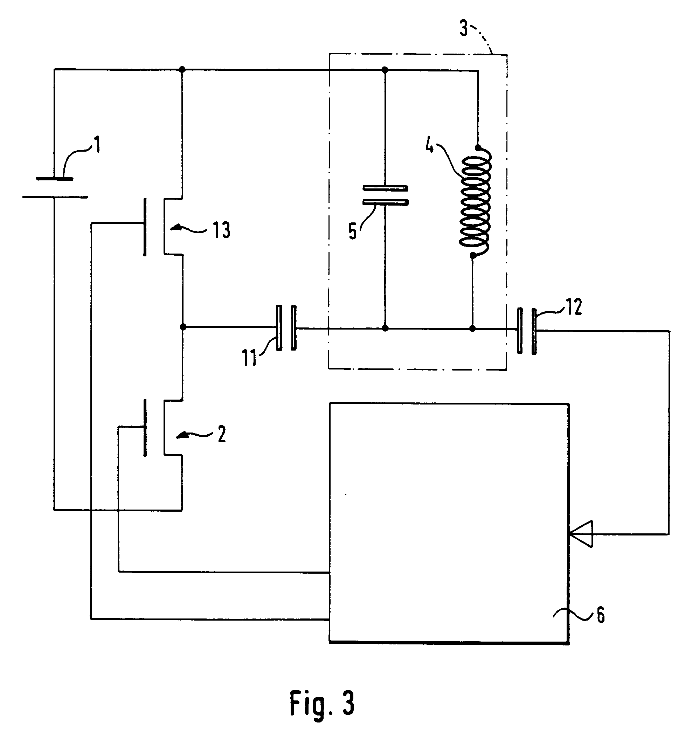

Fig. 3 zeigt eine Ausführung eines Parallelschwingkreises mit kapazitiver Koppelung 11 der Stromquelle 1 sowie kapazitiver Koppelung 12 der Steuerschaltung 6. In dieser Ausführung ist der Schalter 2 als Transistor realisiert. Außerdem ist ein Transistor 13 vorgesehen, der die Entladung des Kondensators 11 vor der Zuschaltung der Stromquelle 1 ermöglicht. Die Kapazität 12 befindet sich zwischen dem Schwingkreis 3 und der Steuerschaltung 6. Die Steuerschaltung 6 empfängt also ein durch die Kapazität 12 kapazitiv gekoppeltes Signal vom Schwingkreis 3. Die Steuerschaltung 6 kann in Abhängigkeit von der Verarbeitung der Schwingkreissignale den als Transistor ausgebildeten Schalter 2 ansteuern. Weiterhin kann die Steuerschaltung 6 den Transistor 13 ansteuern. Der Kondensator 11 befindet sich zwischen dem Schwingkreis 3 und der Stromquelle 1, wobei zwischen dem Kondensator 11 und der Stromquelle 1 der Schalter 2 vorgesehen ist.

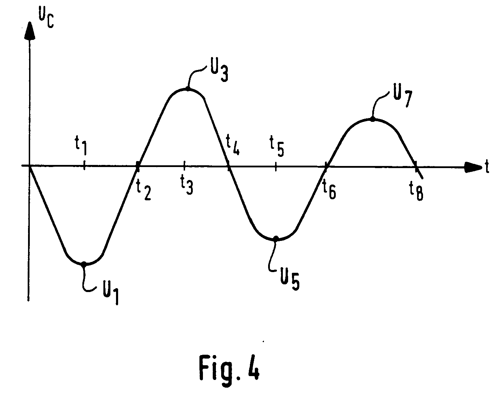

Die Fig. 4 zeigt den Verlauf der Kondensatorspannung UC über der Zeit t bei dem in Fig. 1 gezeigten Parallelschwingkreis. Zur Zeit t0 = 0 wird der Schalter 2 (Fig. 1) geschlossen, so daß die Schwingung des Schwingkreises beginnt. Dies kann mit positiven oder negativen Gradienten erfolgen in Abhängigkeit von der Polarität der Stromquelle. Zum Zeitpunkt t1 erreicht die Kondensatorspannung UC ihren ersten Extremwert U1. Nach dem Nulldurchgang zum Zeitpunkt t2 erreicht die Kondensatorspannung UC dann den zweiten Extremwert U3 zum Zeitpunkt t3. In der Fig. 3 sind weiterhin die Extremwerte U5 und U7 der Kondensatorspannung UC dargestellt. Die Extremwerte verlaufen längs einer abklingenden Kurve. Der Extremwert U7 ist also kleiner als der Extremwert U3. Dementsprechend ist auch der Absolutwert des Extremwertes U5 kleiner als der Absolutwert des Extremwertes U1.

Der optimale Zeitpunkt zum Öffnen des Schalters ist der Zeitpunkt t1. Zu diesem Zeitpunkt t1 erreicht die Spannung UC über der Kapazität 5 ihren ersten Extremwert, bei dem gleichzeitig der Gradient des Stromes durch die Induktivität 4 so gerichtet ist, daß die beim Abschalten entstehende Induktionsspannung mit der Spannung über der Kapazität gleichgerichtet ist. Falls aus irgendeinem Grund zum Zeitpunkt t1 nicht abgeschaltet werden kann, ist der nächstgünstige Abschaltzeitpunkt der Zeitpunkt t5. Zum Zeitpunkt t5 erreicht die Kondensatorspanung UC wiederum einen Extremwert, und gleichzeitig ist auch zum Zeitpunkt t5 der Gradient des Stromes durch die Induktivität so gerichtet, daß die beim Abschalten entstehende Induktionsspannung mit der Spannung über der Kapazität gleichgerichtet ist.

Der ungünstigste Zeitpunkt zum Abschalten ist der Zeitpunkt t3. Zu diesem Zeitpunkt erreicht die Spannung über der Kapazität einen Extremwert U3, der Gradient des Stromes durch die Induktivität jedoch so gerichtet, daß die beim Abschalten entstehende Induktionsspannung mit der Spannung über der Kapazität gerade nicht gleichgerichtet ist, sondern entgegengesetzt zu dieser Spannung ist. Die Schwingung wird also nicht verstärkt, sondern gedämpft.

Für eine optimale Realisierung der Erfindung ist es also erforderlich, den Zeitpunkt t1 zu erkennen und zu diesem Zeitpunkt abzuschalten. Für gewisse Anwendungsfälle kann es jedoch zur Verwirklichung der Erfindung ausreichend sein, einen ausreichend großen Abstand zum ungünstigen Zeitpunkt t3 zu erkennen und dadurch zu verhindern, daß zu diesem ungünstigen Zeitpunkt t3 abgeschaltet wird. Je nach den Gegebenheiten der Schaltung kann es ausreichend sein, beispielsweise den Zeitpunkt t2 zu erkennen und zu diesem Zeitpunkt abzuschalten.

Insbesondere kann es vorteilhaft sein, zu einem Zeitpunkt des Nulldurchgangs, also zu einem der Zeitpunkte t2, t4, t6 oder t8 abzuschalten, da dieser Zeitpunkt bei gewissen Schaltungsrealisierungen besonders einfach zu erkennen ist. Die Abschaltung zum Zeitpunkt t2, also zum Zeitpunkt des ersten Nulldurchganges, hat den besonderen Vorteil, daß dann die im Vergleich zu den anderen Nulldurchgangszeitpunkten größe Amplitude entsteht.

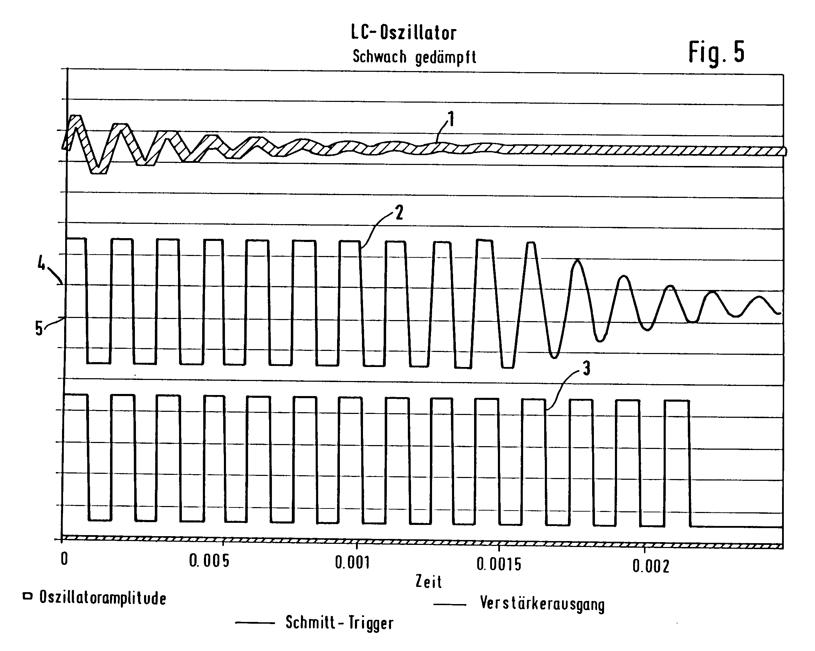

In der Fig. 5 zeigt die Kurve 1 den Verlauf eines Signals des Schwingkreises. Es liegt also eine gedämpfte Schwingung vor. Die Kurve 2 entsteht aus der Kurve 1 dadurch, daß das Signal der Kurve 1 von einem übersteuerten Verstärker verstärkt wird. Hierdurch wird also zunächst ein im wesentlichen rechteckiges Signal erzeugt. Mit dem Absinken der Amplitude der Kurve 1 werden die Flanken der Rechtecke zunehmend flacher, bis sich ein sinusförmiger Verlauf ergibt.

Die Kurve 3 entsteht aus der Kurve 2 dadurch, daß das Signal des Kurvenverlaufs 2 einem Schmitt-Trigger zugeführt wird. Dieser erzeugt digitale Rechtecksignale, solange die ansteigende Flanke der verstärkten Schwingung eine obere Grenze überschreitet ober die abfallende Flanke der verstärkten Schwingung eine untere Grenze unterschreitet. Ansonsten behält der Pegel der Kurve 3 den zuletzt erreichten Wert bei. Diese ist im vorliegenden Fall der untere digitale Pegel.

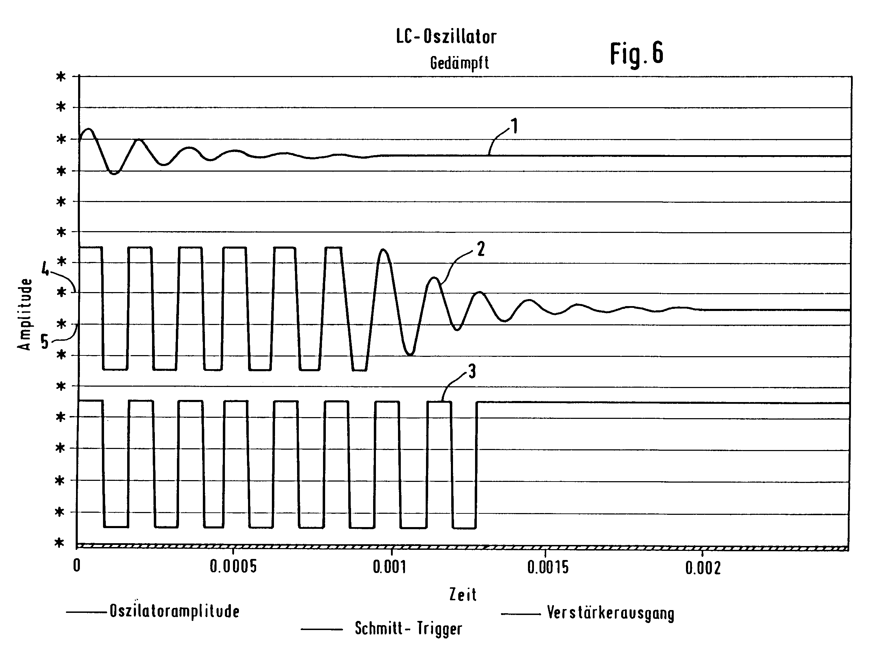

Die Fig. 6 zeigt in einer der Fig. 5 analogen Darstellung die Verhältnisse bei einer stark gedämpften Schwingung des LC-Schwingkreises. Gleiche Kurvenverläufe bzw. Schwellwerte sind dabei mit gleichen Bezugsziffern versehen, so daß auf die Erläuterungen zur Fig. 5 verwiesen werden kann.

Anhand der Kurven 2 in den Fig. 5 und 6 kann man sehen, daß die Nulldurchgangszeitpunkte t2, t4, t6 und t8 gemäß Fig. 4 besonders einfach dadurch ermittelt werden können, daß die Anstiegsflanke bzw. abfallende Flanke des digitalisierten Signals bestimmt wird. Im vorderen, für die Abschaltung relevanten Teil der Kurve 2 trifft dies wegen der Steilheit der Flanken dieser Kurve mit sehr guter Näher zu.

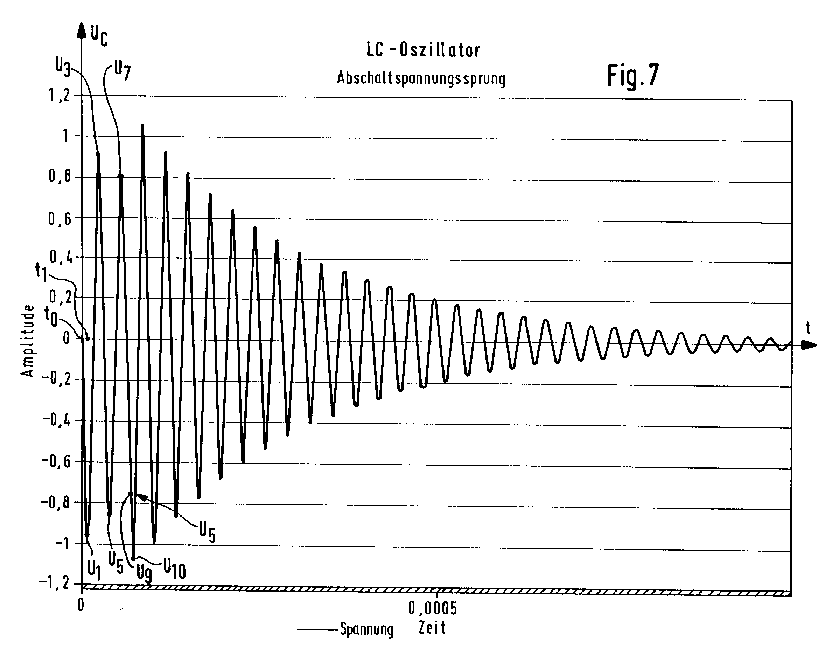

Die Fig. 7 zeigt in einer der Fig. 4 ähnlichen Darstellung einen weiteren Schwingungsverlauf, bei dem die Bezugzeichen denjenigen der Fig. 4 entsprechen. Zum Zeitpunkt t0 = Null wird der Schalter des Parallelschwingkreises geschlossen. Zu diesem Zeitpunkt beginnt damit der Schwingkreis mit seiner Schwingung. Zum Zeitpunkt t1 wird der erste Extremwert U1 erreicht. Es folgen die Extremwerte U3, U5 und U7. Beim Errichen des dritten negativen Extremwertes U9 wird Schalter wieder geöffnet. Da zum Zeitpunkt des dritten negativen Extremwertes U9 der Gradient des Stromes durch die Induktivität so gerichtet ist, daß die beim Abschalten entstehende Induktionsspannung die Schwingung verstärkt, wird im Anschluß an den Extremwert U9 die Amplitude verstärkt; sie erreicht den Wert U10. Die sich daran anschließende Schwingung ist eine längs einer Exponentialkurve abnehmende, gedämpfte Schwingung eines LC-Schwingkreises.

**Patentansprüche**

1. Verfahren zur Erregung eines parallelen Schwingkreises mit einer Induktivität (4), einer Kapazität (5), einer durch einen Schalter (2) schaltbaren Gleichstromquelle (1) und einer Steuerschaltung (6),
   **dadurch gekennzeichnet,**
   daß mittels der Steuerschaltung (6) der Schalter (2) geschlossen wird und anschließend zu einem Zeitpunkt ($t_1$, $t_5$) wieder geöffnet wird, in dem die Spannung (UC) über der Kapazität (5) sich in der Nähe eines Extremwertes (U1, U5) befindet und der Gradient des Stromes durch die Induktivität (4) so gerichtet ist, daß die beim Abschalten entstehende Induktionsspannung die Schwingung verstärkt.

2. Verfahren zur Erregung eines Serienschwingkreises mit einer Induktivität (4), einer Kapazität (5), einer durch einen Umschalter (8) umschaltbaren Gleichspannungsquelle (7) und einer Steuerschaltung (6),
   **dadurch gekennzeichnet,**
   daß mittels der Steuerschaltung (6) der Umschalter (8) in eine erste Lage (9) gebracht wird, in der die Spannungsquelle (7) mit dem Schwingkreis (3) in Serie geschaltet wird, und anschließend in eine zweite Lage (10) gebracht wird, in der der Schwingkreis (3) geschlossen und die Spannungsquelle (7) abgetrennt wird, zu einem Zeitpunkt ($t_1$, $t_5$), in dem die Spannung über der Kapazität (5) sich in der Nähe eines Extremwertes (U1, U5) befindet und der Gradient des Stromes durch die Induktivität (4) so gerichtet ist, daß die beim Abschalten entstehende Induktionsspannung die Schwingung verstärkt.

3. Verfahren nach Anspruch 1 bzw. 2, dadurch gekennzeichnet, daß der Schalter (2) bzw. Umschalter (8) geöffnet bzw. in die zweite Lage (10) gebracht wird, sobald die Spannung über der Kapazität (5) sich in der Nähe des ersten Extremwertes befindet und der Gradient des Stromes durch die Induktivität (4) so gerichtet ist, daß die beim Abschalten entstehende Induktionsspannung die Schwingung verstärkt.

4. Verfahren nach Anspruch 1 bzw. 2, dadurch gekennzeichnet, daß der Schalter (2) bzw. Umschalter (8) geöffnet bzw. in die zweite Lage (10) gebracht wird, sobald die Spannung über der Kapazität (5) sich in der Nähe des Nulldurchgangs befindet.

5. Verfahren nach Anspruch 4, dadurch gekennzeichnet, daß der Schalter (2) bzw. Umschalter (8) geöffnet bzw. in die zweite Lage (10) gebracht wird, sobald die Spannung über der Kapazität (5) sich in der Nähe des ersten Nulldurchgangs befindet.

6. Verfahren nach einem der vorhergehenden Ansprüche, dadurch gekennzeichnet, daß die Stromquelle (1) bzw. Spannungsquelle (7) über ein Koppelglied aus Kapazität (11) oder Induktivität oder Widerstand oder einer Kombination dieser Elemente mit dem Schwingkreis (3) verbunden ist.

7. Verfahren nach einem der vorhergehenden Ansprüche, dadurch gekennzeichnet, daß der Schalter (2) bzw. Umschalter (8) ein Halbleiterschalter ist.

8. Verfahren nach einem der vorhergehenden Ansprüche, dadurch gekennzeichnet, daß die Steuerschaltung (6) über ein Koppelglied aus Kapazität (12) oder Induktivität oder Widerstand oder einer Kombination dieser Elemente mit dem Schwingkreis (3) verbunden ist.

9. Verfahren nach einem der vorhergehenden Ansprüche, dadurch gekennzeichnet, daß die Steuerschaltung ein Differenzierglied aufweist.

10. Verfahren nach einem der vorhergehenden Ansprüche, dadurch gekennzeichnet, daß die Steuerschaltung (6) einen Schwellenwertschalter enthält, der ausreichende Schwingung aufgrund Überschreiten einer Grenzspannung signalisiert.

11. Verfahren nach einem der vorhergehenden Ansprüche, dadurch gekennzeichnet, daß die Steuerschaltung die Schwingungen in Impulse wandelt und eine Auswerteschaltung enthält, die die Impulse digital auswertet.

12. Verfahren nach Anspruch 11, dadurch gekennzeichnet, daß die Schwingungen zunächst durch einen übersteuerten Verstärker verstärkt werden und anschließend durch einen Schmitt-Trigger in Rechteckimpulse konstanter Amplitude (digitale Ausgangswerte) gewandelt werden, solange die ansteigende Flanke der verstärkten Schwingung eine obere Grenze überschreitet oder die abfallende Flanke der verstärkten Schwingung eine untere Grenze unterschreitet.

13. Verfahren nach Anspruch 11 oder 12, dadurch gekennzeichnet, daß die Auswerteschaltung eine Zählschaltung enthält, die die Anzahl der Schwingungen zählt, deren Amplitude einen vorwählbaren Wert überschreitet.

14. Verfahren nach einem der vorhergehenden Ansprüche, dadurch gekennzeichnet, daß die Steuerschaltung einen Pulsgeber beinhaltet, der den Schwingkreis periodisch erregt.

15. Induktiver Näherungssensor zur Durchführung des Verfahrens zur Erregung eines parallelen Schwingkreises nach einem der vorhergehenden Ansprüche mit einem durch Annähern eines elektrisch leitenden Gegenstandes (Dämpfungsglied) bedämpfbaren parallelen Schwingkreis (3) mit einer Induktivität (4), einer Kapazität (5), einer durch einen Schalter (2) schaltbaren Gleichstromquelle (1) und einer Steuerschaltung (6), die die Spannung (Uc) am Kondensator (5) erfaßt und den Schalter (2) steuert.

16. Induktiver Näherungssensor zur Durchführung des Verfahrens zur Erregung eines Serienschwingkreises nach einem der vorhergehenden Ansprüche mit einem durch Annähern eines elektrisch leitenden Gegenstandes (Dämpfungsglied) bedämpfbaren Serienschwingkreis mit einer Induktivität (4), einer Kapazität (5), einer durch einen Umschalter (8) umschaltbaren Gleichspannungsquelle (7) und einer Steuerschaltung (6), die die Spannung (Uc) am Kondensator (5) erfaßt und den Umschalter (8) steuert.

17. Induktiver Näherungssensor nach Anspruch 15 oder 16, dadurch gekennzeichnet, daß die Stromquelle (1) bzw. Spannungsquelle (7) über ein Koppelglied aus Kapazität (11) oder Induktivität oder Widerstand oder einer Kombination dieser Elemente mit dem Schwingkreis (3) verbunden ist.

18. Induktiver Näherungssensor nach einem der Ansprüche 15 bis 17, dadurch gekennzeichnet, daß der Schalter (2) bzw. Umschalter (8) ein Halbleiterschalter ist.

19. Induktiver Näherungssensor nach einem der Ansprüche 15 bis 18, dadurch gekennzeichnet, daß die Steuerschaltung (6) über ein Koppelglied aus Kapazität (12) oder Induktivität oder Widerstand oder einer Kombination dieser Elemente mit dem Schwingkreis (3) verbunden ist.

20. Induktiver Näherungssensor nach einem der Ansprüche 15 bis 19, dadurch gekennzeichnet, daß die Steuerschaltung (6) ein Differenzierglied aufweist.

21. Induktiver Näherungssensor nach einem der Ansprüche 15 bis 20, dadurch gekennzeichnet, daß die Steuerschaltung (6) einen Schwellenwertschalter enthält, der ausreichende Schwingung aufgrund Überschreiten einer Grenzspannung signalisiert.

22. Induktiver Näherungssensor nach einem der Ansprüche 15 bis 21, dadurch gekennzeichnet, daß die Steuerschaltung (6) die Schwingungen in Impulse wandelt und eine Auswerteschaltung enthält, die die Impulse digital auswertet.

23. Induktiver Näherungssensor nach Anspruch 22, dadurch gekennzeichnet, daß die Schwingungen in der Auswerteschaltung zunächst durch einen übersteuerten Verstärker verstärkt werden und anschließend durch einen Schmitt-Trigger in Rechteckimpulse gewandelt werden, solange die ansteigende Flanke der verstärkten Schwingung eine obere Grenze überschreitet oder die abfallende Flanke der verstärkten Schwingung eine untere Grenze unterschreitet.

24. Induktiver Näherungssensor nach Anspruch 22, dadurch gekennzeichnet, daß die Auswerteschaltung eine Zählschaltung beinhaltet, die die Anzahl der Schwingungen zählt, deren Amplitude einen vorwählbaren Wert überschreitet.

25. Induktiver Näherungssensor nach einem der Ansprüche 15 bis 24, gekennzeichnet durch einen Pulsgeber zur periodischen Erregung des Schwingkreises (3).

26. Ereigniszähler, gekennzeichnet durch einen induktiven Näherungssensor nach einem der Ansprüche 15 bis 25.

27. Ereigniszähler nach Anspruch 26, dadurch gekennzeichnet, daß er als Umdrehungszähler ausgestaltet ist.

28. Umdrehungszähler nach Anspruch 27, dadurch gekennzeichnet, daß eine Umdrehung einer Einheit einer zählbaren physikalischen Größe (Länge, Masse, Volumen, Energie) entspricht.

29. Ereigniszähler bzw. Umdrehungszähler nach Anspruch 27 oder 28, dadurch gekennzeichnet, daß der Umdrehungszähler ein Durchflußmengenzähler, insbesondere ein Wasserzähler, ist.

**Claims**

1. A method for generating a parallel resonant circuit with an inductor (4), a capacitor (5), a direct current source (1) switchable by a switch (2) and a control circuit (6), characterized in that the switch (2) is closed by means of the control circuit (6) and is subsequently reopened at a time ($t_1$) when the voltage (UC) over the capacitor (5) is near an extreme value (U1, U5) and the gradient of the current through the inductor (4) is directed in such a way that the induced voltage generated during the switching off reinforces the oscillation.

2. A method for generating a parallel resonant circuit with an inductor (4), a capacitor (5), a direct voltage source (7) switchable by a reversing switch (8) and a control circuit (6), characterized in that the reversing switch (8) is brought by means of the control circuit (6) into a first position (9) wherein the voltage source (7) is disposed in series with the resonant circuit (3), and is subsequently brought into a second position (10) wherein the resonant circuit (3) is closed and the voltage source (7) is separated off at a time ($t_1$, $t_5$) when the voltage over the capacitor (5) is near an extreme value (U1, U5) and the gradient of the current through the inductor (4) is directed in such a way that the induced voltage generated during the switching off reinforces the oscillation.

3. A method according to claim 1 or 2, characterized in that the switch (2) or the reversing switch (8) is respectively opened or brought into the second position (10) as soon as the voltage over the capacitor (5) is near the first extreme value and the gradient of the current through the inductor (4) is directed in such a way that the induced voltage generated during the switching off reinforces the oscillation.

4. A method according to claim 1 or 2, characterized in that the switch (2) or the reversing switch (8) is respectively opened or brought into the second position (10) as soon as the voltage over the capacitor (5) is near the zero voltage.

5. A method according to claim 4, characterized in that the switch (2) and the reversing switch (8) is respectively opened or brought into the second position (10) as soon as the voltage over the capacitor (5) is near the first zero voltage.

6. A method according to one of the preceding claims, characterized in that the current source (1) or the voltage source (7) is connected via a coupling element consisting of a capacitor (11) or inductor or resistor or a combination of these elements to the resonant circuit (3).

7. A method according to one of the preceding claims, characterized in that the switch (2) or the reversing switch (8) respectively is a semiconductor switch.

8. A method according to one of the preceding claims, characterized in that the control circuit (6) is connected via a coupling element consisting of a capacitor (12) or inductor or resistor or a combination of these elements, to the resonant circuit (3).

9. A method according to one of the preceding claims, characterized in that the control circuit has a differentiating element.

10. A method according to one of the preceding claims, characterized in that the control circuit (6) comprises a threshold switch which signals an adequate oscillation on the basis that a critical voltage has been exceeded.

11. A method according to one of the preceding claims, characterized in that the control circuit converts the oscillations into pulses and that it comprises an evaluation circuit which evaluates the pulses digitally.

12. A method according to claim 11, characterized in that the oscillations are first amplified by an overdriven amplifier and are subsequently converted by a Schmitt trigger into rectangular pulses with a constant amplitude (digital output values) as long as the rising side of the amplified oscillation exceeds an upper limit, or the falling side of the amplified oscillation falls below a lower limit.

13. A method according to claim 11 or 12, characterized in that the evaluation circuit comprises a counting circuit counting the number of oscillations whose amplitude exceeds a preselectable value.

14. A method according to one of the preceding claims, characterized in that the control circuit comprises a pulse generator which periodically energizes the resonant circuit.

15. An inductive proximity sensor for operating the method for generating a parallel resonant circuit according to one of the preceding claims, with a parallel resonant circuit (3) dampable by the approach of an electrically conductive object (damping element) with an inductor (4), a capacitor (5), a direct current source (1) switchable by a switch (2) and a control circuit (6) which registers the voltage (Vc) at the capacitor (5) and controls the switch (2).

16. An inductive proximity sensor for operating the method for generating a series resonant circuit according to one of the preceding claims, with a series resonant circuit dampable by the approach of an electrically conductive object (damping element) with an inductor (4), a capacitor (5), a direct voltage source (7) switchable by a reversing switch (8) and a control circuit (6) which registers the voltage (Vc) at the capacitor (5) and controls the switch (8).

17. An inductive proximity sensor according to claim 15 or 16, characterized in that the current source (1) or the voltage source (7) is connected via a coupling element consisting of a capacitor (11) or inductor or resistor or a combination of these elements, to the resonant circuit (3).

18. An inductive proximity sensor according to one of claims 15 to 17, characterized in that the switch (2) or the reversing switch (8) is a semiconductor switch.

19. An inductive proximity sensor according to one of claims 15 to 18, characterized in that the control circuit (6) is connected via a coupling element consisting of a capacitor (12) or inductor or resistor or a combination of these elements, to the resonant circuit (3).

20. An inductive proximity sensor according to one of claims 15 to 19, characterized in that the control circuit (6) has a differentiating element.

21. An inductive proximity sensor according to one of claims 15 to 20, characterized in that the control circuit (6) comprises a threshold switch which signals an adequate oscillation on the basis that a critical voltage has been exceeded.

22. An inductive proximity sensor according to one of claims 15 to 21, characterized in that the control circuit (6) converts the oscillations into pulses and comprises an evaluation circuit which evaluates the pulses digitally.

23. An inductive proximity sensor according to claim 22, characterized in that the oscillations are first amplified in the evaluation circuit by an overdriven amplifier and are subsequently converted by a Schmitt trigger into rectangular pulses as long as the rising side of the amplified oscillation exceeds an upper limit, or the falling side of the amplified oscillation falls below a lower limit.

24. An inductive proximity sensor according to claim 22, characterized in that the evaluation circuit comprises a counting circuit counting the number of oscillations whose amplitude exceeds a preselectable value.

25. An inductive proximity sensor according to one of claims 15 to 24, characterized by a pulse generator for periodically energizing the resonant circuit (3).

26. An event counter characterized by an inductive proximity sensor according to one of claims 15 to 25.

27. An event counter according to claim 26, characterized in that it is designed as a revolution counter.

28. A revolution counter according to claim 27, characterized in that one revolution corresponds to a unit of a countable physical quantity (length, mass, volume, energy).

29. An event counter or revolution counter according to claim 27 or 28, characterized in that the revolution counter is a flowmeter, in particular a water meter.

**Revendications**

1. Procédé pour l'excitation d'un circuit oscillant parallèle comprenant une inductance (4), une capacité (5), et une source de courant continu (1) pouvant être commuté par un commutateur (2) ainsi qu'un circuit de commande (6),

   caractérisé en ce que le commutateur (2) est fermé au moyen du circuit de commande (6) et est ouvert de nouveau à un instant de temps $(t_1)$ pendant lequel la tension (UC) entre les bornes de la capacité (5) est située à proximité d'une valeur extrême (U1, U5), et où le gradient du courant est dirigé par l'inductivité (4) de façon que la tension d'induction se produisant lors de la coupure renforce l'oscillation.

2. Procédé pour l'excitation d'un circuit série oscillant comprenant une inductance (4), une capacité (5), une source de courant continu (7) pouvant être commuté par un commutateur (8) ainsi qu'un circuit de commande (6),

   caractérisé en ce que le commutateur (8) est amené au moyen du circuit de commande (6) dans une première position (9), dans laquelle la source de tension (7) est commutée en série avec le circuit oscillant (3) et est amené ensuite dans une deuxième position (10) dans laquelle le circuit oscillant (3) est fermé et la source de tension (7) séparée, à un instant de temps $(t_1, t_5)$ pendant lequel la tension entre les bornes de la capacité (5) est située à proximité d'une valeur extrême (U1, U5), et où le gradient du courant est dirigé par l'inductance (4) de façon que la tension d'inductance se produisant lors de la coupure renforce l'oscillation.

3. Procédé selon la revendication 1 ou 2, caractérisé en ce que le commutateur (2) ou le commutateur (8) est ouvert ou amené dans la deuxième position (10) dès que la tension au-dessus de la capacité (5) est située à proximité de la première valeur extrême, et où le gradient du courant est dirigé par l'inductance (4) de façon que la tension d'inductance (4) se produisant lors de la coupure renforce l'oscillation.

4. Procédé selon la revendication 1 ou 2, caractérisé en ce que le commutateur (2) ou le commutateur (8) est ouvert ou amené dans la deuxième position (10) dès que la tension au-dessus de la capacité (5) est située à proximité du passage à zéro.

5. Procédé selon la revendication 4, caractérisé en ce que le commutateur (2) ou le commutateur (8) est ouvert ou amené dans la deuxième position (10), dès que la tension au-dessus de la capacité (5) est située à proximité du premier passage à zéro.

6. Procédé selon l'une des revendications précédentes, caractérisé en ce que la source de courant (1) ou la source de tension (7) est reliée par un élément de couplage constitué d'une capacité (11) ou d'une inductance ou d'une résistance ou d'une combinaison de ces éléments avec le circuit oscillant (3).

7. Procédé selon l'une des revendications précédentes, caractérisé en ce que le commutateur (2) ou le commutateur (8) est un commutateur semi-conducteur.

8. Procédé selon l'une des revendications précédentes, caractérisé en ce que le circuit de commande (6) est relié par un élément de couplage constitué d'une capacité (12) ou d'une inductance ou d'une résistance ou d'une combinaison de ces éléments avec le circuit oscillant (3).

9. Procédé selon l'une des revendications précédentes, caractérisé en ce que le circuit de commande possède un élément différenciateur.

10. Procédé selon l'une des revendications précédentes, caractérisé en ce que le circuit de commande (6) comprend un commutateur à valeur de seuil qui signalise une oscillation suffisante sur la base d'un dépassement d'une tension limite.

11. Procédé selon l'une des revendications précédentes, caractérisé en ce que le circuit de commande convertit les oscillations en des impulsions et comprend une circuit d'exploitation qui exploite les impulsions numériquement.

12. Procédé selon la revendication 11, caractérisé en ce que les oscillations sont renforcées d'abord au moyen d'un amplificateur saturé et sont converties ensuite au moyen d'une bascule de Schmitt en des impulsions carrées d'amplitude constante (valeurs initiales numériques) aussi longtemps que le flanc montant de l'oscillation renforcée dépasse une limite supérieure ou que le flanc descendant de l'oscillation renforcée passe en-dessous d'une limite inférieure.

13. Procédé selon la revendication 11 ou 12, caractérisé en ce que le circuit d'exploitation comprend un circuit compteur qui compte le nombre d'oscillations dont l'amplitude dépasse une valeur pouvant être présélectionnee.

14. Procédé selon l'une des revendications précédentes, caractérisé en ce que le circuit de commande comprend un générateur d'impulsions qui excite périodiquement le circuit oscillant.

15. Capteur d'approche inductif pour la mise en oeuvre du procédé pour l'excitation d'un circuit oscillant parallèle selon l'une des revendications précédentes comprenant un circuit oscillant parallèle (3) pouvant être amorti par le rapprochement d'un objet conducteur électriquement (élément d'amortissement) comportant une inductance (4), une capacité (5), une source de courant continu (1) pouvant être commutée par un commutateur (2) ainsi qu'un circuit de commande (6) qui capte la tension (Vc) au condensateur (5) et commande le commutateur (2).

16. Capteur d'approche inductif pour la mise en oeuvre du procédé pour l'excitation d'un circuit série oscillant selon l'une des revendications précédentes, comprenant un circuit série oscillant pouvant être amorti par l'approche d'un objet conducteur électriquement (élément d'amortissement) comportant une inductance (8), une capacité (5), une source de courant continu (7) pouvant être commutée par un commutateur (8) et un circuit de commande (6) qui capte la tension (Vc) au condensateur (5) et commande le commutateur (8).

17. Capteur d'approche inductif selon la revendication 15 ou 16, caractérisé en ce que la source de courant (1) ou la source de courant (7) est reliée par un élément de couplage constitué d'une capacité (11) ou d'une inductance ou d'une résistance ou d'une combinaison de ces éléments avec le circuit oscillant (3).

18. Capteur d'approche inductif selon l'une des revendications 15 à 17, caractérisé en ce que le commutateur (2) ou le commutateur (8) est un commutateur semi-conducteur.

**19.** Capteur d'approche inductif selon l'une des revendications 15 à 18, caractérisé en ce que le circuit de commande (6) est relié par un élément de couplage constitué d'une capacité (12) ou d'une inductance ou d'une résistance ou d'une combinaison de ces éléments avec le circuit oscillant (3).

**20.** Capteur d'approche inductif selon l'une des revendications 15 à 19, caractérisé en ce que le circuit de commande (6) comporte un élément différenciateur.

**21.** Capteur d'approche inductif selon l'une des revendications 15 à 20, caractérisé en ce que le circuit de commande (6) comprend un commutateur à valeur de seuil qui signale une oscillation suffisante sur la base d'un dépassement d'une tension limite.

**22.** Capteur d'approche inductif selon l'une des revendications 15 à 21, caractérisé en ce que le circuit de commande (6) convertit les oscillations en des impulsions et comprend un circuit d'exploitation qui exploite les impulsions numériquement.

**23.** Capteur d'approche inductif selon la revendication 22, caractérisé en ce que les oscillations sont amplifiées dans le circuit d'exploitation d'abord par l'intermédiaire d'un amplificateur saturé et sont converties ensuite par une bascule de Schmitt en des impulsions carrées aussi longtemps que le flanc montant de l'oscillation renforcée dépasse une limite supérieure ou que le flanc descendant de l'oscillation renforcée va en-dessous d'une limite inférieure.

**24.** Capteur d'approche inductif selon la revendication 22, caractérisé en ce que le circuit d'exploitation comprend un circuit compteur qui compte le nombre des oscillations dont l'amplitude dépasse une valeur pouvant être présélectionnée.

**25.** Capteur d'approche inductif selon l'une des revendications 15 à 24, caractérisé par un générateur d'impulsions pour l'excitation périodique du circuit oscillant (3).

**26.** Compteur d'évènements, caractérisé par un capteur d'approche inductif selon l'une des revendications 15 a 25.

**27.** Compteur d'évènements selon la revendication 26, caractérisé en ce que celui-ci est réalisé sous la forme d'un compteur de tours.

**28.** Compteur de tours selon la revendication 27, caractérisé en ce qu'une révolution correspond à une unité d'une grandeur physique pouvant être comptée (longueur, masse, volume, énergie).

**29.** Compteur d'évènements ou compteur de tours selon la revendication 27 ou 28, caractérisé en ce que le compteur de tours est un compteur de la quantité du débit d'écoulement, notamment un compteur d'eau.

Fig.1

Fig. 2

Fig. 3

Fig. 4

## LC-Oszillator
### Schwach gedämpft

Fig. 5

Zeit

□ Oszillatoramplitude      —— Verstärkerausgang

—— Schmitt-Trigger

EP 0 311 128 B1

## LC-Oszillator

Gedämpft

## Fig. 6

EP 0 311 128 B1

——Oszilatoramplitude ——Verstärkerausgang

—— Schmitt-Trigger

LC -Oszillator
Abschaltspannungssprung

Fig.7

EP 0 311 128 B1

Spannung    Zeit